# FASCICULE DE BREVET EUROPEEN

(11) **EP 0 918 385 B1**
(45) Date de publication et mention de la délivrance du brevet: **09.07.2003**
(21) Numéro de dépôt: 98420207.7
(22) Date de dépôt: 18.11.1998
(51) Int. Cl.: H02B 1/052, H02B 1/20, H01R 9/26, H01R 9/24, H05K 7/14

(54) **Dispositif d'interface entre équipements d'une installation**
Schnittstellenvorrichtung zwischen Teilen einer Anlage
Interface device for use between units of an installation

(30) Priorité: 19.11.1997 FR 9714507
(43) Date de publication de la demande: 26.05.1999
(73) Titulaire: ENTRELEC SA, 69627 Villeurbanne Cedex (FR)
(72) Inventeur: Bechaz, Bernard, 69300 Caluire (FR); Gaillard, Jean-Paul, 69008 Lyon (FR); Louis-Chevrau, Christophe, 69008 Lyon (FR)
(74) Mandataire: Maureau, Philippe

(56) Documents cités:
- DE-A- 2 507 904
- DE-C- 4 410 817
- DE-C- 4 438 805
- US-A- 4 872 092

## Description

L'invention concerne un dispositif d'interface électrique et/ou optique pour une installation industrielle où un premier équipement, notamment de type automate, est relié à au moins un autre par le dispositif d'interface auquel il est raccordé par l'intermédiaire d'au moins un connecteur multipoint (voir DE 2507904).

De nombreuses installations industrielles comporte des équipements et notamment des automate industriels dont le fonctionnement implique le raccordement à au moins un autre équipement, notamment à un équipement de gestion, par des liaisons filaires électriques et/ou optiques de transmission de signaux et d'énergie.

Par ailleurs il est fréquent que le raccordement d'un équipement à un autre nécessite une adaptation afin que ce que transmet l'un puisse être exploité par l'autre et réciproquement si nécessaire. Il est donc habituel de réaliser des dispositifs d'interface permettant de telles adaptations entre équipements. Un tel dispositif d'interface peut être directement incorporé à un équipement à interconnecter avec un autre, être réparti dans les deux équipements à interconnecter ou encore être constitué comme une unité indépendante à laquelle les équipements sont connectés par des liaisons filaires.

Comme il est connu, la réalisation d'un dispositif d'interface sous la forme d'une unité indépendante présente notamment l'avantage de permettre une exploitation de deux équipements après raccordement sans avoir à modifier matériellement ces équipements, lorsque ceux-ci ne sont pas prévus dès l'origine pour fonctionner directement l'un avec l'autre sans aucune adaptation. Les équipements à interconnecter par l'intermédiaire d'un telle unité se relient à elle par l'intermédiaire de liaisons et il est classique de doter les liaisons de connecteurs mâles ou femelles leur permettant de s'accoupler à des éléments connecteurs complémentaires portés par l'unité et/ou par les équipements pour permettre des connexions, déconnexions rapides ainsi que des substitutions faciles d'équipement ou d'unité d'interface, en cas de besoin.

Il existe donc de nombreux dispositifs d'interface entre équipements qui sont réalisés sous la forme d'unités indépendantes auxquelles viennent se raccorder les équipements à interconnecter.

Il est par ailleurs courant de rassembler physiquement les interfaces de raccordement d'une même installation ou d'un même ensemble fonctionnel d'une installation, avec un certain nombre d'organes de raccordement électrique et/ou optique et par exemple des blocs de jonction exploités pour la distribution d'énergie électrique, notamment pour faciliter les interventions du personnel de maintenance.

Dans une forme connue de réalisation, les blocs de jonction ainsi que d'autres organes de raccordement comportent des pieds d'accrochage qui permettent de les monter sur des rails de support ayant une forme et des dimensions normalisées. Il existe des interfaces telles qu'évoquées ci-dessus qui sont réalisées sous la forme de cartes de circuit imprimé et qui sont associées à des moyens permettant de les monter sur des rails supports, chaque carte comportant des pistes conductrices et portant des composants électriques, électroniques et/ou optiques.

Le document FR-A-2548511 décrit notamment un montage simplifié d'un dispositif de type platine permettant de monter une carte de circuit imprimé sur un rail de support normalisé, parallèlement à ce rail, au moyen de deux pieds de fixation au rail sur lesquels viennent se monter quatre barrettes, respectivement dites de maintien et de verrouillage de carte, qui viennent immobiliser cette carte par ses rives.

Il est ainsi possible de réaliser simplement des dispositifs d'interface pour des équipements très divers par assemblage et raccordement selon des techniques très largement répandues après réalisation d'un circuit électrique approprié en utilisant des pistes conductrices réalisées sur une carte de circuit imprimé.

Une très grande souplesse de réalisation est donc offerte aux concepteurs, elle a toutefois l'inconvénient de conduire à une très grande variété de réalisations puisque les normes en la matière sont minimales et il peut être difficile de trouver une carte de remplacement directement substituable à une carte défaillante. Il peut aussi être nécessaire de remplacer toute une carte pour pouvoir effectuer une modification relativement mineure, si une telle modification n'a pas été prévue et si l'agencement initialement prévu de la carte ne s'y prête pas.

Par ailleurs les cartes de circuit imprimé présentent l'inconvénient d'être relativement fragiles si l'on prend en considération les éléments avec lesquelles elles sont susceptibles de voisiner sur un rail de support et les liaisons par fils ou câbles avec lesquelles elles peuvent être amenées à coopérer.

L'invention propose donc un dispositif d'interface, doté d'organes servant d'intermédiaire entre un premier équipement en particulier de type automate et au moins un autre équipement d'une installation industrielle, qui est apte à accueillir au moins un connecteur multipoint de raccordement du premier équipement. Ce dernier est notamment prévu pour desservir des canaux de communication entre des éléments fonctionnels du premier équipement et des éléments fonctionnels d'au moins ledit autre équipement qui sont établis par l'intermédiaire de fils et/ou fibres de liaison électrique ou optique.

Selon une caractéristique de l'invention, le dispositif d'interface est réalisé sous la forme d'un ensemble modulaire dont les organes sont répartis dans un alignement de boîtiers fonctionnels, de type bloc de jonction, accolés et éventuellement interconnectés électriquement et/ou optiquement, où chaque canal de communication est desservi par un boîtier fonctionnel contenant les organes de l'interface qui assurent les fonctions relatives à ce canal et accueillant la partie de connecteur multipoint desservant ce canal. Les différentes fonctions réalisées par le dispositif d'interface sont réparties dans différents boîtiers fonctionnels dudit alignement.

Des fonctions d'adaptation, de commutation, de relayage de commande, de protection et/ou de signalisation sont réparties dans les différents boîtiers fonctionnels de l'ensemble modulaire qui correspondent aux canaux pour lesquelles elles sont respectivement mises en oeuvre.

Selon une forme de réalisation de l'invention, le dispositif est constitué par un alignement de boîtiers accolés apte à accueillir au moins un connecteur multipoint d'un premier équipement qui définissent ensemble au moins un connecteur multipoint complémentaire de ce connecteur de premier équipement, les dits boîtiers ayant une épaisseur, selon leur axe d'alignement qui est égale ou multiple du pas dudit connecteur.

L'invention, ses caractéristiques et ses avantages sont précisés dans la description qui suit en liaison avec les figures évoquées ci-dessous.

La figure 1 présente un exemple d'un dispositif d'interface connu associé à un équipement d'un ensemble d'équipements.

La figure 2 présente un exemple de dispositif d'interface selon l'invention, un connecteur d'équipement et un boîtier montré séparé.

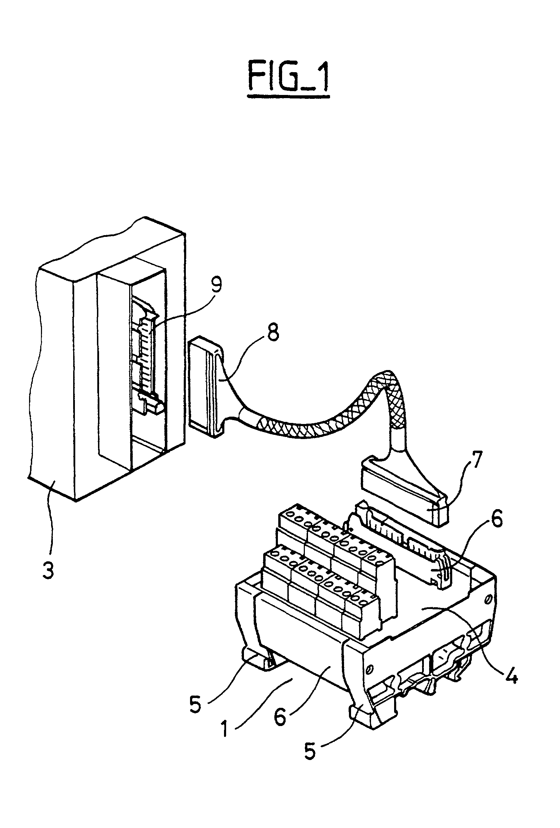

Comme indiqué ci-dessus, la figure 1 présente un dispositif d'interface 1 connu à côté duquel est placée une liaison filaire de desserte 2 supposée prévue pour mettre électriquement et/ou optiquement en communication le dispositif d'interface avec un premier équipement 3 d'une installation industrielle comportant au moins deux équipements dont seul le premier d'entre eux est représenté. Ces équipements sont supposés dotés d'éléments fonctionnels, non représentés, que le dispositif d'interface 1 permet de mettre en communication.

A cet effet, le dispositif d'interface 1 comporte des organes permettant d'assurer la compatibilité entre les équipements que le dispositif d'interface relie, si besoin est.

Le dispositif d'interface 1 connu est réalisé sous la forme d'une platine comportant une carte de circuit imprimé 4 montée dans un cadre comportant deux pieds de fixation 5 sur rail normalisé et deux traverses 6 qui relient les pieds et participent au maintien de la carte dans le cadre.

Divers organes du dispositif d'interface 1, en particulier des composants électriques, électroniques et/ou optiques, sont susceptibles d'être montés sur la carte à des fins d'adaptation entre équipements, comme déjà indiqué ci-dessus, ou à d'autres fins et par exemple pour des besoins de commutation, signalisation ou protection.

Dans l'exemple présenté sur la figure 1, il est notamment prévu une embase correspondant à un connecteur multipoint mâle 6 destiné à recevoir un connecteur femelle complémentaire 7 qui équipe la liaison 2. L'embase du connecteur mâle 6 est fixée sur la carte de circuit imprimé 4, par exemple par boulonnage, et elle est reliée à des pistes conductrices de cette carte par une extrémité de chacune des pièces de connexion mâles qu'elle comporte. Ces dernières, non représentées, sont enfichées, par exemple, dans des trous métallisés ménagés au niveau des pistes dans la carte.

La liaison 2 est ici supposée dotée d'un connecteur 8 lui permettant de venir se raccorder à un connecteur complémentaire 9 du premier équipement 9 pour permettre de relier sélectivement des éléments fonctionnels, non représentés, de ce premier équipement aux différents fils de la liaison et en conséquence à des organes correspondants prévus au niveau du dispositif d'interface 1. Les éléments fonctionnels du premier équipement sont susceptibles d'être très divers, certains d'entre eux sont par exemple du type capteur, d'autres sont par exemple de type actionneur.

Dans l'exemple de réalisation présenté sur la figure 1, la carte de circuit imprimé 4 est supposée porter deux rangées de bornes de connexion destinées, par exemple, à permettre le raccordement de fils, non représentés, provenant d'au moins un autre équipement, lui aussi non représenté, de l'ensemble qui comporte le premier équipement 3 pour la mise en communication de ces équipements par l'intermédiaire du dispositif d'interface 1.

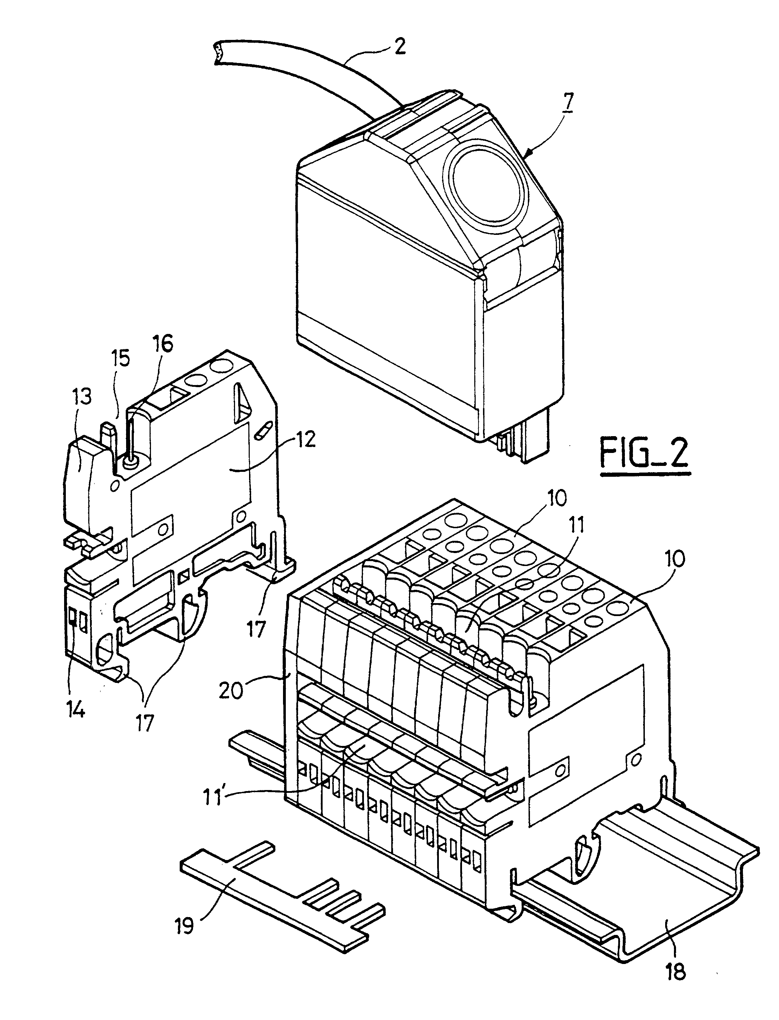

L'exemple de dispositif d'interface 1', selon l'invention, présenté en figure 2 est lui aussi supposé destiné à être associé à au moins deux équipements d'une installation industrielle, non représentés ici, dont il met des équipements fonctionnels en communication en assurant de nécessaires adaptations, si besoin est.

Ce dispositif d'interface 1' est constitué par un alignement de boîtiers fonctionnels 10, se présentant par exemple sous la forme de blocs de jonction, qui sont accolés et qui forment ensemble un ensemble modulaire apte à accueillir au moins un connecteur multipoint 7 prévu pour desservir notamment des canaux de communication entre des éléments fonctionnels d'un premier équipement et des éléments fonctionnels d'au moins un autre équipement d'une installation. Les boîtiers alignés se répartissent les organes permettant au dispositif d'interface de réaliser les différentes fonctions qui lui sont imparties. Chaque canal de communication est desservi par un boîtier 10 qui contient les organes assurant les fonctions réalisées au niveau du dispositif d'interface pour ce canal, ce boîtier accueille aussi la partie d'un connecteur multipoint 7 qui est relative au canal qu'il dessert.

Les différentes fonctions susceptibles d'être réalisées et les organes susceptibles d'être incorporés dans les boîtiers 10 seront développées plus loin.

L'accueil d'un connecteur au niveau d'un dispositif d'interface selon l'invention s'effectue par l'intermédiaire d'un connecteur complémentaire, soit par exemple d'un connecteur mâle complémentaire, si le connecteur 7 affecté au premier équipement est un connecteur femelle. Dans l'exemple envisagé sur la figure 2, le connecteur 7 est supposé équiper une liaison filaire de desserte 2 d'un premier équipement d'une installation industrielle.

A cet effet chaque boîtier 10 est, par exemple, réalisé sous la forme d'une demi-coque en matériau isolant moulé dont le fond 12 et éventuellement la paroi de pourtour 13, en périphérie de ce fond. Ce fond et cette paroi de pourtour sont intérieurement garnis de reliefs, non représentés qui, selon une technique bien connue, permettent de positionner divers organes électriques et/ou optiques. Ces organe sont notamment des éléments d'interconnexion électrique, par exemple du genre barrette, des bornes de connexion pour des fils électriques, par exemple de type à vis et étrier ou de type à fente de dénudage et de maintien, des composants électriques, ou encore des composants électroniques ou électromécaniques, ainsi que leurs équivalents optiques ou optoélectroniques.

La paroi de pourtour 12 d'un boîtier est classiquement perforée ou échancrée à des emplacements déterminés pour former des ouvertures permettant de faire passer des éléments de l'extérieur à l'intérieur du boîtier. Comme il est connu, ceci est indispensable lorsque le logement, que délimite une demi-coque d'un boîtier et la paroi de pourtour 13 qui la borde, est fermé par un fond d'un autre boîtier ou par un flasque d'extrémité, tel 20, venant en appui sur la rive du pourtour du boîtier sur lequel il se fixe, lorsque le dispositif d'interface 1' est assemblé avec les boîtiers qui le composent accolés. Comme il est connu de telles ouvertures, telles celles référencées 14, permettent notamment l'insertion de fils et/ou fibres externes dans le dispositif d'interface au niveau des différents boîtiers, par exemple pour connexion de fils ou fibres externes à des bornes de connexion logées dans les boîtiers.

Dans la réalisation envisagée, au moins une ouverture pour un conduit référencé 15 est aussi ménagée dans la paroi de pourtour 13 par exemple au sommet de chaque boîtier pour permettre l'introduction d'une partie complémentaire d'un connecteur multipoint externe 7.

Le conduit 15 est ici supposé être un conduit de guidage destiné à coopérer avec une partie de connecteur externe 7 formée de manière à pouvoir pénétrer en coulissant dans ce conduit, jusqu'à connexion complète d'au moins une pièce de connexion comportée par le conduit avec au moins une pièce de connexion complémentaire, non représentée, comportée par la partie de connecteur externe 7.

Le conduit de guidage 15 est par exemple limité par des reliefs saillant intérieurement du fond de la demi-coque que forme un boîtier jusqu'au niveau de son ouverture dans la paroi de pourtour 12 de ce boîtier. Il est ici supposé comporter un fond d'ou saille une pièce de connexion 16 de type broche, la pièce complémentaire étant par exemple de type pince élastique, comme connu en la matière.

Les conduits de guidage 15 des différents boîtiers communiquent latéralement entre eux dans la mesure ou chacun d'eux s'ouvre sur sa longueur dans la paroi constituant le fond 12 du boîtier qui le comporte. Chaque boîtier définit donc une partie élémentaire d'un connecteur multipoint 11 qui n'est formé que lorsque le boîtier est accolé à un nombre déterminé de boîtiers identiques ou éventuellement similaires alignés. Le nombre de boîtiers de dispositif d'interface nécessaire à la réalisation d'un connecteur complémentaire d'un connecteur extérieur donné est bien entendu fonction du nombre de voies de communication à desservir et donc de points de connexion que comporte le connecteur extérieur et l'épaisseur des boîtiers selon leur axe d'alignement est nécessairement correspondant au pas commun à leurs points de connexion et à ceux du connecteur extérieur envisagé. Il doit être compris qu'une voie de communication ici supposée monofilaire peut éventuellement mettre en oeuvre plus d'un fil ou d'une fibre distincte et donc impliquer l'usage de plus d'un point de connexion au niveau d'un connecteur multipoint qui la dessert.

La répartition des points ou pièces de connexion du connecteur extérieur est, bien entendu, étroitement liée à celle du connecteur complémentaire constituée par des boîtiers accolés, elle est ici supposée linéaire avec un point c'est-à-dire une pièce de connexion individuelle par conduit de guidage 15, il est bien entendu possible d'envisager des réalisations avec des connecteurs où les points sont répartis sur plus d'une ligne dans un même ou dans plusieurs conduits par boîtier.

Il est envisageable de réaliser des boîtiers avec une épaisseur et donc un pas multiple du pas propre aux points de connexion d'un connecteur extérieur, ceci n'étant pas développé ici dans la mesure où une telle adaptation est du domaine de l'homme de métier.

Il est aussi possible de réaliser des dispositifs d'interface comportant plus d'un connecteur réalisé au moyen de boîtiers accolés et alignés, les connecteurs réalisés étant susceptibles d'être soient alignés et réalisés à l'aide de boîtiers distincts, soient parallèles et portés par les mêmes boîtiers alors dotés d'un ou de plusieurs conduits 15 appropriés, comme le montre la figure 2 ou deux connecteurs distincts 11 et 11' sont représentés.

Dans l'exemple de réalisation présenté en figure 2, l'alignement des boîtiers 10 est prévu réalisé au long d'un rail de support sur lequel ces boîtiers viennent alors se monter, soit successivement soit en tant qu'ensemble pré-assemblé. Ceci est notamment le cas si, comme dans l'exemple présenté en figure 2, les boîtiers comportent des pieds de fixation 17 destinés à permettre leur assujettissement sur un rail de support normalisé 18.

Le pré-assemblage des boîtiers 10 d'un dispositif d'interface peut s'effectuer à l'aide de moyens amovibles de solidarisation entre boîtiers du même dispositif. ce pré-assemblage peut par exemple être réalisé, par un ou des éléments de solidarisation commun aux boîtiers ou encore par encliquetage d'éléments de fixation portés par un boîtier dans des éléments de fixation complémentaires portés par un boîtier auquel il est accolé, chaque boîtier comportant des éléments de fixation et des éléments complémentaires répartis par exemple de part et d'autre de sa paroi de fond. Comme il est connu, l'un des boîtiers situés à l'une extrémité est alors susceptible d'être équipé d'un flasque de fermeture, dans la mesure où il n'est prévu aucun autre boîtier pour venir l'obturer .Il est ainsi possible de constituer un dispositif d'interface sous la forme d'un tout isolément manipulable avant installation, les boîtiers formant ce tout étant dissociables pour permettre le démontage de l'un quelconque de ces boîtiers, si besoin est.

Comme indiqué plus haut, il est prévu que chacun des boîtiers d'un alignement qui sont accolés pour constituer un connecteur loge les différents organes propres au canal de communication desservi par la partie de connecteur que le boîtier considéré comporte pour coopérer avec un connecteur externe complémentaire.

Ceci est notamment réalisé pour la ou les pièces de connexion 16 de la partie de connecteur 11 ou 11' que le boîtier comporte. Dans la mesure ou dans de nombreux cas et en particulier avec les automates industriels, les éléments fonctionnels à mettre en relation par l'intermédiaire d'un dispositif d'interface sont électriquement ou optiquement accessibles selon des configurations polaires simples ou dissociables de manière simple par exemple des configurations mono, bi, tri ou quadripolaires, il est possible de prévoir des boîtiers standardisés de dispositif d'interface selon l'invention qui permettent d'assurer le raccordement par connecteur de ces équipements à des dispositifs d'interface comportant des connecteurs réalisés par alignement de boîtiers accolés. Les fonctions réalisées au niveau d'un boîtier fonctionnel sont notamment des fonctions d'adaptation, de commutation, de relayage de commande, de protection et/ou de signalisation.

Les fonctions d'adaptation sont par exemple susceptibles d'être réalisées à l'aide de circuits simples connus en eux-mêmes et notamment électriques, électroniques ou électro-optiques montés dans un boîtier et reliés à au moins une pièce de connexion 16 d'une partie d'un connecteur comportée par ce boîtier et suivant les cas à au moins une autre pièce de connexion d'une partie d'un autre connecteur de ce boîtier ou à au moins une borne de connexion également comportée par ce boîtier pour le raccordement d'un fil ou d'une fibre externe. Chaque boîtier peut ainsi comporter au moins une entrée et/ou une sortie supplémentaire le plus souvent mono, bi, tri ou quadrifilaire en plus d'au moins une pièce de connexion appartenant à une partie d'un connecteur qu'il comporte. Une entrée/sortie monofilaire d'un boîtier est susceptible d'être effectuée directe , sectionnable ou protégée par fusible, avec, le cas échéant, un organe de type sectionneur ou de type fusible logé dans le boîtier qui la comporte. Une entrée/sortie bifilaire est notamment susceptible de desservir un capteur en transmettant séparément un potentiel par exemple commun à une pluralité de boîtiers et un signal en retour propre au boîtier considéré. Une entrée/sortie trifilaire est par exemple susceptible de desservir un capteur en transmettant séparément deux potentiels communs à une pluralité de boîtiers et un signal en retour propre au boîtier considéré.

Il est prévu de réaliser des dispositifs d'interface constitués à l'aide d'alignements de boîtiers accolés réalisés de manière standardisée avant installation pour répondre à des demandes de dispositifs pour des équipements et notamment des automates réalisés en série. Ces dispositifs présentent l'avantage de pouvoir être facilement dissociés en cas de besoin de modification ou de réparation et de permettre dans de nombreux cas une mise à niveau ou un dépannage par simple substitution d'un boîtier à un autre.. Ces blocs forment alors un tout qu'il est possible de manipuler isolément et de déplacer à volonté, par exemple pour une vente sous forme d'ensemble pré-monté.

Il est également prévu de relier électriquement entre elles des bornes du dispositif d'interface situées sur des boîtiers différents du dispositif par des éléments conducteurs d'interconnexion, comme le peigne d'interconnexion externe 19 pourvu de dents qui sont destinées à venir se positionner dans les orifices d'insertion de fil de bornes alignées de boîtiers accolés en permettant l'introduction de fils extérieurs et en assurant une mise en liaison électrique de ces bornes, les dents étant sectionnables de manière à permettre une réalisation des mises en liaison avec seulement certaines des bornes d'un alignement ou pour permettre d'avoir un pas multiple du pas initial des dents.

Il est aussi prévu d'utiliser des éléments d'interconnexion interne parallèles à l'axe d'alignement des boîtiers accolés, ces éléments de type tige conductrice passant alors par des ouvertures ménagées au même niveau dans les parois de fond respectives des boîtiers d'un alignement pour établir une liaison électrique avec des parties conductrices d'organes électriques logés dans les boîtiers.

Tout ceci permet de constituer une grande partie des circuits mono, bi, tri ou quadripolaires notamment électriques usuellement mis en oeuvre dans les dispositifs d'interface et en particulier d'incorporer les plus communs de ces circuits dans des boîtiers identiques ou compatibles entre eux. Le circuit contenu dans un boîtier est relié à la ou aux pièces de connexion de partie(s) élémentaire(s) de connecteur(s) propre(s) à ce boîtier, ainsi qu'aux éventuelle(s) borne(s) et au(x) éventuel(s) élément(s) d'interconnexion associé(s) au boîtier.

## Revendications

1. Dispositif d'interface (1'), doté d'organes servant d'intermédiaire entre un premier équipement (3) en particulier de type automate et au moins un autre équipement d'une installation industrielle, apte à accueillir au moins un connecteur multipoint (7) notamment prévu pour desservir des canaux de communication entre des éléments fonctionnels du premier équipement et des éléments fonctionnels de l'autre équipement au moins qui sont établis par l'intermédiaire de fils et/ou fibres de liaison électrique ou optique, **caractérisé en ce qu'**il comprend un ensemble modulaire dont les organes sont répartis dans un alignement de boîtiers fonctionnels (10), de type bloc de jonction, qui sont accolés et éventuellement interconnectés électriquement et/ou optiquement, où chaque boîtier (10) définit une partie élémentaire d'un connecteur multipoint (11), où chaque canal de communication est desservi par un boîtier fonctionnel (10) contenant les organes de l'interface qui assurent les fonctions relatives à ce canal et accueillant la partie de connecteur multipoint (7) desservant ce canal, les différentes fonctions réalisées par le dispositif d'interface étant réparties dans différents boîtiers fonctionnels de l'ensemble.

2. Dispositif d'interface selon la revendication 1 **caractérisé en ce que** chaque canal de communication est desservi par un boîtier fonctionnel (10) contenant les organes de l'interface qui assurent les fonctions relatives à ce canal et accueillant la partie de connecteur multipoint desservant ce canal,.

3. Dispositif d'interface, selon la revendication 1 ou 2, dans lequel des fonctions d'adaptation, de commutation, de relayage de commande, de protection et/ou de signalisation sont réparties dans les différents boîtiers fonctionnels de l'ensemble modulaire qui correspondent aux canaux pour lesquelles elles sont respectivement mises en oeuvre.

4. Dispositif d'interface, selon l'une des revendications 1 à 3, comportant un ensemble modulaire constitué par un alignement de boîtiers accolés apte à accueillir au moins un connecteur multipoint d'un premier équipement qui définissent ensemble au moins un connecteur multipoint (11) complémentaire de ce connecteur de premier équipement

5. Dispositif d'interface, selon la revendication 4 caractérisé les boîtiers fonctionnels possèdent une épaisseur, selon leur axe d'alignement, qui est égale ou multiple du pas des deux connecteurs multipoints.

6. Dispositif d'interface, selon l'une des revendications 1 à 5, **caractérisé en ce qu'**il comporte un ensemble modulaire constitué par un alignement de boîtiers accolés qui définissent ensemble des connecteurs multipoints (11, 11') parallèles et/ou alignés.

7. Dispositif d'interface, selon l'une des revendications 1 à 6, **caractérisé en ce qu'**il comporte des moyens de solidarisation entre boîtiers alignés qui sont dissociables, lui permettant de former un tout isolément manipulable, démontable si besoin est.

## Patentansprüche

1. Interface-Einrichtung (1'), bestückt mit Vermittlungsorganen zwischen einer ersten Baugruppe (3), insbesondere einer Automatenbaugruppe, und mindestens einer weiteren Baugruppe einer technischen Anlage, die dazu ausgebildet ist, mindestens einen Mehrfachverbinder (7) aufzunehmen, der insbesondere dazu ausgelegt ist, Kommunikationskanäle zwischen Funktionselementen der ersten Baugruppe und Funktionselementen der wenigstens einen weiteren Baugruppe zu versorgen, die mittels elektrischer oder optischer Verbindungsleitungen und/oder -fasern hergestellt sind, **dadurch gekennzeichnet, dass** sie eine Modulanordnung, deren Organe in einer Reihenanordnung von Funktionseinheiten (10) verteilt sind, vom Typ Reihenklemme umfasst, die angebaut und gewünschtenfalls elektrisch und/oder optisch miteinander verbunden sind, wobei jede Einheit (10) ein Elementarteil eines Mehrfachverbinders (11) definiert, wobei jeder Kommunikationskanal von einer Funktionseinheit (10) versorgt wird, die die Interface-Organe enthält, welche die Funktionen bezüglich dieses Kanals sicherstellen, und den Teil des Mehrfachverbinders (7) aufnimmt, der diesen Kanal versorgt, wobei die durch die Interface-Einrichtung realisierten verschiedenen Funktionen auf verschiedene Funktionseinheiten der Anordnung verteilt sind.

2. Interface-Einrichtung nach Anspruch 1, **dadurch gekennzeichnet, dass** jeder Kommunikationskanal durch eine Funktionseinheit (10) versorgt wird, die die Interface-Organe enthält, die die Funktionen bezüglich dieses Kanals sicherstellen, und den Teil des Mehrfachverbinders aufnimmt, der diesen Kanal versorgt.

3. Interface-Einrichtung nach Anspruch 1 oder 2, bei der die Funktionen der Anpassung, der Umschaltung, der Befehlsvermittlung, der Schutzbereitstellung und/oder der Signalgabe auf die verschiedenen Funktionseinheiten der Modulanordnung verteilt sind, welche den Kanälen entsprechen, für die sie jeweils eingesetzt werden.

4. Interface-Einrichtung nach einem der Ansprüche 1 bis 3, umfassend eine Modulanordnung, gebildet durch eine Reihenanordnung von angebauten Einheiten, die zur Aufnahme mindestens eines Mehrfachverbinders einer ersten Baugruppe ausgebildet ist, die zusammen mindestens einen zu diesem Verbinder der ersten Baugruppe komplementären Mehrfachverbinder (11) definieren.

5. Interface-Einrichtung nach Anspruch 4, **dadurch gekennzeichnet, dass** die Funktionseinheiten entlang ihrer Reihenanordnungsachse eine Dicke aufweisen, welche gleich der Teilung oder einem Mehrfachen der Teilung der zwei Mehrfachverbinder ist.

6. Interface-Einrichtung nach einem der Ansprüche 1 bis 5, **dadurch gekennzeichnet, dass** sie eine Modulanordnung umfasst, gebildet durch eine Reihenanordnung von angebauten Einheiten, die zusammen parallel und/oder in Reihe angeordnete Mehrfachverbinder (11, 11') definieren.

7. Interface-Einrichtung nach einem der Ansprüche 1 bis 6, **dadurch gekennzeichnet, dass** sie Mittel zur Befestigung zwischen in Reihe angeordneten Einheiten umfasst, welche lösbar sind und es ihr ermöglichen, eine erforderlichenfalls demontierbare, einzeln handhabbare Gesamtheit zu bilden.

## Claims

1. Interface device (1'), provided with components used as an intermediary between a first equipment (3), in particular of the robot type, and at least one other equipment of an industrial plant, capable of receiving at least one multipoint connector (7) intended especially for serving communication channels between the functional elements of the first equipment and the functional elements of the other equipment at least which are established by means of wires and/or fibres for electrical or optical connection, **characterised in that** it comprises a modular assembly, whose components are distributed in an alignment, of functional units (10) of the junction box type which are adjacent and optionally interconnected electrically and/or optically, where each unit (10) defines an elementary part of a multipoint connector (11), where each communication channel is served by a functional unit (10) containing the interface components which fulfil the functions relating to this channel and receiving the multipoint connector part (7) serving this channel, the various functions performed by the interface device being distributed in various functional units of the assembly.

2. Interface device according to Claim 1, **characterised in that** each communication channel is served by a functional unit (10) containing the interface components which fulfil the functions relating to this channel and receiving the multipoint connector part serving this channel.

3. Interface device according to Claim 1 or 2, **characterised in that** the matching, switching, control relay, protection and/or signalling functions are distributed in the various functional units of the modular assembly which correspond to the channels for which they are respectively implemented.

4. Interface device according to one of Claims 1 to 3, having a modular assembly consisting of an alignment of adjacent units which is capable of receiving at least one multipoint connector of a first equipment, which together define at least one multipoint connector (11) complementary to this first equipment connector.

5. Interface device according to Claim 4, **characterised in that** the functional units have a thickness, along their alignment axis, which is equal to or a multiple of the step of the two multipoint connectors.

6. Interface device according to one of Claims 1 to 5, **characterised in that** it has a modular assembly consisting of an alignment of adjacent units which together define parallel and/or aligned multipoint connectors (11, 11').

7. Interface device according to one of Claims 1 to 6, **characterised in that** it has means for attachment between aligned units which are detachable, allowing it to form an independently manipulatable, optionally removable entity.
